# EUROPÄISCHE PATENTSCHRIFT

(11) **EP 1 421 836 B1**
(45) Veröffentlichungstag und Bekanntmachung des Hinweises auf die Patenterteilung: **26.10.2005**
(21) Anmeldenummer: 02797630.7
(22) Anmeldetag: 27.08.2002
(51) Int. Cl.: H05K 7/14, H04Q 3/00, G06F 13/40

(54) **BAUGRUPPE UND ENTSPRECHENDE RÜCKWAND**
MODULE AND CORRESPONDING REAR PANEL
MODULE ET PANNEAU ARRIERE CORRESPONDANT

(30) Priorität: 28.08.2001 EP 01120509
(43) Veröffentlichungstag der Anmeldung: 26.05.2004
(73) Patentinhaber: SIEMENS AKTIENGESELLSCHAFT, 80333 München (DE)
(72) Erfinder: SCHNABEL, Dirk, D-81369 München (DE)
(86) Internationale Anmeldenummer: PCT/EP2002/009558
(87) Internationale Veröffentlichungsnummer: WO 2003/021975

(56) Entgegenhaltungen:
- EP-A- 0 460 626
- US-A- 5 983 294

## Beschreibung

Diese Erfindung betrifft eine Baugruppe gemäß dem Oberbegriff des Patentanspruchs 1, eine Rückwand gemäß dem Oberbegriff des Patentanspruchs 7 sowie einen bidirektionalen Multiplexer für die Baugruppe.

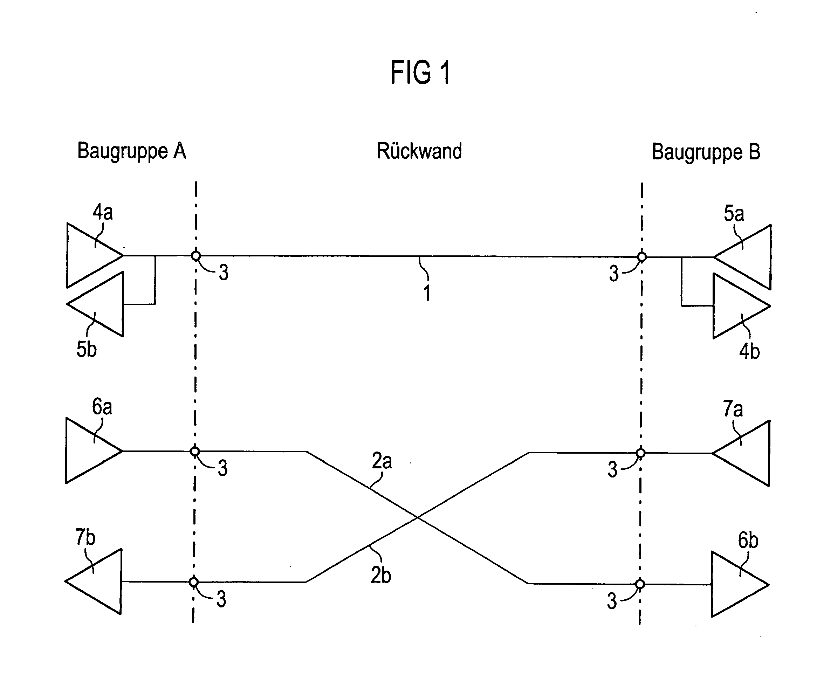

Modular aufgebaute elektrische Geräte können durch Einstecken verschiedener Baugruppen an spezielle Aufgaben angepasst werden. So kann beispielsweise eine Telefonvermittlungsanlage durch Einschieben einer ausreichenden Zahl von Baugruppen an die gewünschte Zahl von Nebenstellen angepasst werden. Typischerweise kommunizieren die Baugruppen über eine Rückwand miteinander, wie dies in Fig. 1 schematisch dargestellt ist. Auf der Rückwand werden bidirektionale Leitungen 1 und unidirektionale Leitungen 2a und 2b unterschieden. An einer bidirektionalen Leitung sind an jeder Seite sowohl ein Sender 4a und 5a als auch ein Empfänger 4b und 5b angeschlossen. Unidirektionale Leitungen werden an einer Seite von einem Sender 6a und 7a getrieben und sind an ihrem anderen Ende mit einem Empfänger 6b bzw. 7b verbunden.

Kommunizieren zwei Baugruppen mit der gleichen elektrischen Schnittstelle miteinander, so muss vermieden werden, dass eine Leitung gleichzeitig von zwei Sendern getrieben wird. Eine bidirektionale Leitung auf der Rückwand kann zwei sich entsprechende Steckverbindungen der beiden Baugruppen miteinander verbinden, weil durch Aktivieren bzw. Deaktivieren der Sender für diese Steckverbindung dafür Sorge getragen wird, dass maximal ein Sender die Leitung treibt.

Unidirektionale Leitungen werden typischerweise auf der Rückwand gekreuzt, so dass zwar sich entsprechende Steckverbindungen auf beiden Baugruppen möglicherweise von zwei Sendern getrieben werden, diese jedoch mit zwei anderen Steckverbindungen der jeweils anderen Baugruppe verbunden sind, wie dies in Fig. 1 für Leitungen 2a und 2b dargestellt ist. So verbindet in Fig. 1 die Leitung 2a den Sender 6a mit dem Empfänger 6b. Entsprechend verbindet die Leitung 2b den Sender 7a mit dem Empfänger 7b.

Wird nun eine neue Baugruppengeneration entwickelt, so ist die Anzahl der bidirektionalen und unidirektionalen Verbindungen fest von der Rückwand vorgegeben. Ein bidirektionales Leitungspaar kann bei Verwendung identischer Baugruppen nicht für zwei unidirektionale Signale verwendet werden, da in diesem Fall zwei Sender dieselbe Leitung treiben würden oder eine Leitung die Eingänge von zwei Empfängern miteinander verbinden würde. Ohne Änderung der Rückwand und gemäß der herkömmlichen Technik kann über ein auf der Rückwand gekreuztes Leitungspaar lediglich ein bidirektionales Signal geschickt werden, weil durch die Kreuzung der Leitungen das Signal nicht über sich entsprechende Steckverbindungen gesendet und empfangen wird.

Sollte die neue Baugruppengeneration leistungsfähiger werden, so war in der Regel auch eine höhere Datenrate über die Rückwand zu übertragen. Dies konnte durch Vorsehen einer größeren Zahl von Verbindungen geschehen oder durch Umwandeln von unidirektionalen Leitungen in indirektionale Leitungen. Herkömmlicherweise war deshalb ein Redesign der Rückwand erforderlich, bei dem beispielsweise gekreuzte Leitungen durch ungekreuzte Leitungen ersetzt wurden. Ein Ersetzen der Rückwand führt allerdings dazu, dass das elektronische Gerät vorübergehend außer Betrieb genommen werden muss und so der Austausch der Rückwand zu einer längeren Betriebsunterbrechung führt. Im Unterschied dazu sind Baugruppen so ausgelegt, dass sie auch bei laufendem Gerät gewechselt werden können.

Es ist somit die Aufgabe der Erfindung, eine Baugruppe, eine Rückwand sowie einen bidirektionalen Multiplexer anzugeben, die die Entwicklung einer leistungsfähigeren Baugruppengeneration ohne Redesign der Rückwand ermöglichen.

Diese Aufgabe wird durch eine Baugruppe nach Anspruch 1 und eine Rückwand nach Anspruch 7.

Im Folgenden werden bevorzugte Ausführungsformen dieser Erfindung anhand der beiliegenden Zeichnungen näher erläutert. Dabei zeigen:
Fig. 1 schematisch die elektrische Verbindung zweier Baugruppen A und B über eine Rückwand mittels einer bidirektionalen Leitung und zwei unidirektionaler Leitungen und
Fig. 2 zwei Baugruppen A und B, die je mit einem bidirektionalen Multiplexer zum Kompensieren des Kreuzens der beiden Verbindungsleitungen ausgerüstet sind.

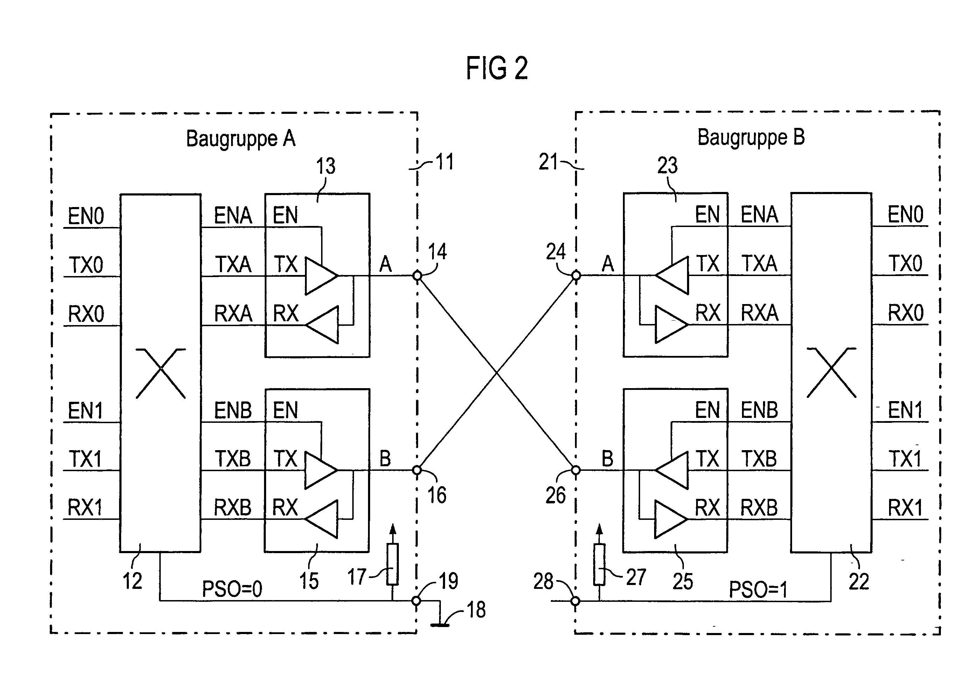

Die Erfindung beruht im Wesentlichen darauf, dass das Kreuzen zweier zunächst unidirektional verwendeter Leitungen in einer der über die Rückwand verbundenen Baugruppen kompensiert wird. Dies kann im einfachsten Fall dadurch geschehen, dass auf einer Baugruppe die Anschlüsse für die Steckverbindungen gegenüber der anderen Baugruppe vertauscht angeschlossen werden. Diese Vertauschung kann beispielsweise dadurch realisiert werden, dass der Anschluss B von IO-Puffer 25 (IO steht für Input/Output, zu deutsch Eingabe/Ausgabe) mit Steckverbindung 24 und der Anschluss A von IO-Puffer 23 mit Steckverbindung 26 in Fig. 2 verbunden wird. Gemäß dieser Ausführungsform der Erfindung sind die Verbindungsleitungen nicht nur auf der Rückwand sondern auch in der Baugruppe B gekreuzt. Beide Kreuzungen heben sich auf. In dieser Ausführungsform sind die bidirektionalen Multiplexer 12 und 22 nicht erforderlich. Diese Ausführungsform hat jedoch den Nachteil, dass zwei unterschiedliche Baugruppen entwickelt und hergestellt werden müssen, nämlich eine mit gekreuzten, die andere mit ungekreuzten Anschlüssen. Auch wird der Service komplizierter, da unterschiedliche Baugruppen vorgehalten werden müssen und beim Einstecken der falschen Baugruppe die Funktion des elektronischen Geräts gestört oder sogar das Gerät zerstört werden kann.

Deshalb erscheint die in Fig. 2 dargestellte Ausführungsform vorteilhaft, weil zumindest die elektronische Schnittstelle der Baugruppen A und B identisch ist und folglich auch die gesamten Baugruppen identisch sein können.

In Fig. 2 ist beispielhaft die Ansteuerung eines auf der Rückwand gekreuzten Leitungspaares dargestellt, wobei jede Leitung Signale in beide Richtungen übertragen kann. Dies wird durch die IO-Puffer 13, 15, 23 und 25 erreicht. Jeder dieser Puffer enthält einen aktivierbaren Sender mit den Eingängen EN und TX. Über die Eingänge TX erhalten die Sender die zu sendenden Daten. Die Eingänge EN dienen zur Aktivierung des jeweiligen Senders. Die Sender können in einer Ausführungsform mit Tri-State-Ausgängen ausgerüstet sein. In einer anderen Ausführungsform können die Sender aus einem Undgatter und einem Transistor mit offenem Kollektor oder Drain bestehen. Hier werden die Leitungen vorzugsweise auf der Rückwand mit der entsprechenden Versorgungsspannung, also entweder Masse oder vorzugsweise 5 V verbunden. Die in den IO-Puffern vorgesehenen Empfänger, die die Ausgangssignale RX liefern, können beispielsweise durch Inverter realisiert werden.

Sowohl in Baugruppe A als auch in Baugruppe B ist je ein bidirektionaler Multiplexer 12 bzw. 22 vorgesehen. Jedem der beiden bidirektionalen Multiplexer wird ein Steuersignal POS zugeführt. Ferner stellt jeder Multiplexer vier Anschlussgruppen zur Verfügung, wobei jede Anschlussgruppe drei Anschlüsse ENx, TXx sowie RXx umfasst."x" steht für 0, 1, A oder B entsprechend der jeweiligen Anschlussgruppe. Die Schaltcharakteristik der Multiplexer 12 und 22 ergibt sich aus Tabelle 1.

| Eingänge | POS=0 (Baugruppe A) Ausgänge | POS=1 (Baugruppe B) Ausgänge |
|---|---|---|
| ENA | EN0 | EN1 |
| TXA | TX0 | TX1 |
| RX0 | RXA | RXB |
| ENB | EN1 | EN0 |
| TXB | TX1 | TX0 |
| RX1 | RXB | RXA |

Aus Tabelle 1 ergibt sich, dass in Baugruppe A, in der das Steuersignal POS den Wert 0 hat, die Anschlüsse EN0, TX0, RX0, EN1, TX1, RX1 mit den Anschlüssen ENA, TXA, RXA, ENB, TXB bzw. RXB durch den Multiplexer 12 verbunden werden. Da bei Baugruppe B das Steuersignal POS den Wert 1 besitzt, also auf positiver Betriebsspannung liegt, kreuzt der Multiplexer 22 die Anschlussgruppen. Somit sind die Anschlüsse EN0, TX0, RX0 EN1, TX1 und RX1 mit den Anschlüssen ENB, TXB, RXB, ENA, TXA bzw. RXA verbunden.

Das Steuersignal POS wird dadurch abhängig von der Position auf der Rückwand, in die die Baugruppe eingesteckt wird, dadurch erzeugt, dass der Steckkontakt 19 der einen Position mit Masse über die Masseverbindung 18 verbunden ist, während die Steckverbindung 28 in der Rückwand offen gelassen wird. Innerhalb der Baugruppen sind die Widerstände 17 bzw. 27 vorgesehen, über die die Leitung für das Steuersignal mit der positiven Betriebsspannung, also vorzugsweise 5 V verbunden wird. Die Widerstände 17 bzw. 27 sorgen dafür, dass die Steuerleitung auf eine definierte Spannung gelegt wird, auch wenn die Steckverbindung 28 auf der Rückwand nicht angeschlossen wird.

In einer anderen Ausführungsform kann die Steckverbindung 28 auf der Rückwand mit der positiven Betriebsspannung verbunden werden. In dieser Ausführungsform sind die Widerstände 17 und 27 nicht erforderlich.

Die Anschlussgruppe A mit den Anschlüssen ENA, TXA und RXA sowie die Anschlussgruppe B mit den Anschlüssen ENB, TXB und RXB der bidirektionalen Multiplexer 12 und 22 sind an die Steuerleitung EN, die Sendedatenleitung TX sowie die Empfangsdatenleitung RX der entsprechenden IO-Puffer angepasst. Entsprechen die Logikpegel der Anschlussgruppe 0 mit den Anschlüssen ENO, TXO und RXO und der Anschlussgruppe 1 mit den Anschlüssen EN1, TX1, RX1 den Logikgpegeln der Anschlüsse der IO-Puffer, so können die Multiplexer 12 und 22 auf einfache Weise bei einem Redesign in die Baugruppen eingefügt werden.

Die bidirektionalen Multiplexer 12 und 22 bestehen in der bevorzugten Ausführungsform aus sechs Einzelmultiplexern, von denen jeder zwei Eingänge und einen Ausgang besitzt. Jeder Ausgang ENA, TXA, RX0, ENB, TXB und RX1 sind mit einem Ausgang eines Einzelmultiplexers verbunden. Je ein Eingang der Einzelmultiplexer, deren Ausgänge mit den Anschlüssen ENA und ENB verbunden sind, sind mit den Anschlüssen EN0 und EN1 verbunden. Entsprechend sind die zwei Einzelmultiplexer für die Anschlüsse TXx angeschlossen. Je ein Eingang der Einzelmultiplexer, die mit den Ausgängen RX0 und RX1 verbunden sind, sind mit den Anschlüssen RXA und RXB verbunden.

In einer anderen Ausführungsform kann ein bidirektionaler Multiplexer zwischen die Anschlüsse A und B der IO-Puffer 13 und 15 und die Steckverbindungen 14 und 16 geschaltet sein. Ein solcher Multiplexer müsste aus zwei bidirektionalen Einzelmultiplexern bestehen.

In allen Ausführungsformen dieser Erfindung arbeiten die Schnittstellen-Bausteine, also die bidirektionalen Multiplexer 12 und 22 sowie die IO-Puffer 13, 15, 23 und 25 so, dass die Anschlüsse EN0 bis RX1 in der Baugruppe 11 transparent mit den Anschlüssen EN0 bis RX1 in Baugruppe 21 verbunden sind.

In den obigen Ausführungsformen wurde lediglich die Beschaltung eines auf der Rückwand gekreuzten Leitungspaars beschrieben, um einen bidirektionalen Betrieb jeder Leitung des Leitungspaars zu ermöglichen. Neben diesem Leitungspaar können eine beliebige Anzahl bidirektionaler, ungekreuzter Leitungen sowie eine beliebige Anzahl auf der Rückwand gekreuzter Leitungspaare vorhanden sein, von denen wiederum ein Teil unidirektional und der Rest bidirektional betrieben wird.

## Patentansprüche

1. Baugruppe zum Einstecken in ein Gerät mit einer Rückwand, wobei die Rückwand ein gekreuztes Leitungspaar mit einer ersten Leitung (2a) und einer zweiten Leitung (2b) umfasst, und die Baugruppe über je eine Steckverbindung (3; 14, 16, 24, 26) mit den Leitungen des gekreuzten Leitungspaares der Rückwand verbindbar ist,
**dadurch gekennzeichnet,**
**dass** die Baugruppe eine Einrichtung umfasst, die das Kreuzen des Leitungspaares in der Rückwand kompensiert.

2. Baugruppe nach Anspruch 1,
**dadurch gekennzeichnet,**
**dass** mit jeder Steckverbindung (14, 16, 24, 26) für das gekreuzte Leitungspaar der Ausgang eines aktivierbaren Senders und der Eingang eines Empfängers verbunden sind, und jeder Sender nur dann aktiviert ist, wenn kein mit dem Ausgang des Senders über die entsprechende Leitung der Rückwand verbundene dritter Sender aktiviert ist.

3. Baugruppe nach Anspruch 2,
**dadurch gekennzeichnet, dass** der aktivierbare Sender und der Empfänger, die mit derselben Steckverbindung verbunden sind, einen IO-Pufferbaustein bilden, der zwei Eingänge (TX, EN) und einen Ausgang (RX) aufweist.

4. Baugruppe nach einem der obigen Ansprüche,
**dadurch gekennzeichnet,**
**dass** die Einrichtung, die das Kreuzen der Leitungspaare in der Rückwand kompensiert, durch einen bidirektionalen Multiplexer (12, 22) gebildet wird.

5. Baugruppe nach Anspruch 4,
**dadurch gekennzeichnet,**
**dass** eine weitere Steckverbindung (19, 28) vorgesehen ist, über die der Multiplexer (12, 20) die Information erhält, ob er die von der ersten Leitung empfangenen oder über diese gesendeten Signale mit denen über die zweite Leitung empfangenen oder über diese gesendeten Signale vertauschen soll oder nicht.

6. Baugruppe nach Anspruch 4 oder 5, soweit sich Anspruch 4 auf Anspruch 3 rückbezieht,
**dadurch gekennzeichnet,**
**dass** der Multiplexer (12, 22) vier Anschlussgruppen aufweist, von denen zwei mit den IO-Pufferbausteinen verbunden sind, die wiederum mit den Leitungen eines gekreuzten Leitungspaares verbunden sind.

7. Rückwand zum Einstecken von zwei weitgehend gleichen Baugruppen (11, 12), wobei für jede Baugruppe eine Vielzahl von Steckverbindungen (14, 16, 19, 24, 26, 28) in der gleichen geometrischen Anordnung vorgesehen ist und ein Paar von Steckverbindungen (14, 16) für die erste Baugruppe (11) mit dem entsprechenden Paar von Steckverbindungen (24, 26) für die zweite Baugruppe (21) über gekreuzte Leitungen verbunden ist,
**dadurch gekennzeichnet,**
**dass** eine Steckverbindung (19) für die erste Baugruppe (11) auf der Rückwand mit einem bestimmten Potential verbunden ist und die entsprechende Steckverbindung (28) für die zweite Baugruppe (21) auf der Rückwand mit einem anderen Potential verbunden oder auf der Rückwand unverbunden ist.

## Claims

1. Module for insertion into a device having a rear panel, the rear panel comprising a crossed line pair with a first line (2a) and a second line (2b), and the module being connectable via one plug-in connection (3; 14, 16 24) in each case to the lines of the crossed line pair of the rear panel, **characterised in that**
**characterised in that**
the module comprises a device that compensates for the crossing of the pair of lines in the rear panel.

2. Module according to claim 1,
**characterised in that**
with each plug-in connection (14, 16, 24, 26) for the crossed pair of lines, the output of an activatable transmitter and the input of a receiver are connected, and each transmitter is activated only when no third transmitter connected to the output of the transmitter via the corresponding line of the rear panel is activated.

3. Module according to claim 2,
**characterised in that**
the activatable transmitter and the receiver which are connected to the same plug-in connection form an IO buffer component which has two inputs (TX, EN) and one output (RX).

4. Module according to one of the above claims,
**characterised in that**
the device that compensates for the crossing of the pairs of lines in the rear panel is formed by a bidirectional multiplexer (12, 22).

5. Module according to claim 4,
**characterised in that**
a further plug-in connection (19, 28) is provided via which the multiplexer (12, 20) receives the information as to whether or not it is to transpose the signals received from the first line or transmitted over said first line with the signals received from the second line or transmitted over said second line.

6. Module according to claim 4 or 5, insofar as claim 4 refers back to claim 3,
**characterised in that**
the multiplexer (12, 22) has four groups of terminals, two of which are connected to the IO buffer components which in turn are connected to the lines of a crossed pair of lines.

7. Rear panel for inserting two largely identical modules (11, 12), a plurality of plug-in connections (14, 16, 19, 24, 26, 28) being provided in the same geometrical arrangement for each module and a pair of plug-in connections (14, 16) for the first module (11) being connected to the corresponding pair of plug-in connections (24, 26) for the second module (21) via crossed lines,
**characterised in that**
one plug-in connection (19) for the first module (11) is connected on the rear panel to a specific potential and the corresponding plug-in connection (28) for the second module (21) is connected on the rear panel to another potential or is unconnected on the rear panel.

## Revendications

1. Module destiné à être fiché dans un appareil pourvu d'un panneau arrière, le panneau arrière comprenant une paire de lignes croisées avec une première ligne (2a) et une deuxième ligne (2b) et le module pouvant être relié aux lignes de la paire de lignes croisées du panneau arrière par le biais d'une connexion par fiche respective (3; 14, 16, 24, 26),
**caractérisé en ce que**
le module comprend un dispositif qui compense le croisement de la paire de lignes dans le panneau arrière.

2. Module selon la revendication 1,
**caractérisé en ce que**
la sortie d'un émetteur pouvant être activé et l'entrée d'un récepteur sont reliées à chaque connexion par fiche (14, 16, 24, 26) pour la paire de lignes croisées et chaque émetteur n'est activé que lorsqu'aucun troisième émetteur relié à la sortie de l'émetteur par le biais de la ligne correspondante du panneau arrière n'est activé.

3. Module selon la revendication 2,
**caractérisé en ce que**
l'émetteur pouvant être activé et le récepteur reliés à la même connexion par fiche forment un bloc modulaire tampon E/S pourvu de deux entrées (TX, EN) et d'une sortie (RX).

4. Module selon l'une des revendications précédentes,
**caractérisé en ce que**
le dispositif compensant le croisement des paires de lignes dans le panneau arrière est formé par un multiplexeur bidirectionnel (12, 22).

5. Module selon la revendication 4,
**caractérisé en ce que**
l'on prévoit une connexion par fiche supplémentaire (19, 28) par le biais de laquelle le multiplexeur (12, 20) obtient l'information indiquant s'il doit échanger les signaux reçus par la première ligne ou émis par le biais de celle-ci avec les signaux reçus par le biais de la deuxième ligne ou émis par le biais de celle-ci.

6. Module selon la revendication 4 ou 5, dans la mesure où la revendication 4 se réfère à la revendication 3,
**caractérisé en ce que**
le multiplexeur (12, 22) est pourvu de quatre groupes de connexions dont deux sont reliés aux blocs modulaires tampons E/S qui sont à leur tour reliés aux lignes d'une paire de lignes croisées.

7. Panneau arrière destiné au fichage de deux modules (11, 12) largement identiques, une pluralité de connexions par fiche (14, 16, 19, 24, 26, 28) ayant la même disposition géométrique étant prévue pour chaque module et une paire de connexions par fiche (14, 16) pour le premier module (11) étant reliée à la paire de connexions par fiche (24, 26) correspondante pour le deuxième module (21) par le biais de lignes croisées,
**caractérisé en ce**
**qu'**une connexion par fiche (19) pour le premier module (11) sur le panneau arrière est reliée à un potentiel déterminé et la connexion par fiche (28) correspondante pour le deuxième module (21) sur le panneau arrière est reliée à un autre potentiel ou n'est pas reliée sur le panneau arrière.
